# EUROPEAN PATENT APPLICATION

(11) **EP 4 800 925 A1**
(43) Date of publication of application: **02.09.2026**
(21) Application number: 26155630.2
(22) Date of filing: 02.02.2026
(51) Int. Cl.: H03M 1/10, H03M 1/16

(54) **SYSTEMS AND METHODS FOR COMMON-MODE REJECTION IN SIGNAL PROCESSING SYSTEMS**

(30) Priority: 26.02.2025 US 202519063999
(71) Applicant: Avago Technologies International Sales Pte. Limited, Singapore 768923 (SG)
(72) Inventor: Ragab, Kareem Abdelghani Ibraheem Mohamed, Irvine, CA, 92620 (US); Chandrasekhar, Vinay, Irvine, CA, 92602 (US); Jiang, Xicheng, Irvine, CA, 92612 (US)
(74) Representative: Grünecker Patent- und Rechtsanwälte PartG mbB

(57) **Abstract**

The subject technology is directed to signal processing systems and methods. In an embodiment, the subject technology provides an apparatus that includes a first input terminal and a second input terminal configured to receive respective input signals. A first converter and a second converter generate corresponding output signals based on the input signals. A first circuit, coupled to both converters, determines a gain mismatch between them based on their output signals and adjusts at least one of the signals to compensate for the mismatch. By compensating for gain mismatch in the digital domain, the apparatus improves the common-mode rejection ratio (CMRR) and enhances the accuracy and reliability of analog-to-digital conversion. There are other embodiments as well.

## Description

### FIELD OF INVENTION

The subject technology is directed to signal processing systems and methods.

### BACKGROUND OF THE INVENTION

Analog-to-digital converters (ADCs) are important components in modern electronic systems, enabling the conversion of analog signals into digital representations for processing and storage. ADCs are widely used in various applications, including health sensing devices, industrial automation, communication systems, and/or the like. To ensure accurate signal conversion, ADC architectures must effectively reject common-mode interference while preserving the integrity of differential signals. For example, the term "common-mode interference" may refer to unwanted signals or noise that appear simultaneously on both signal leads of a differential circuit. Common-mode interference may arise from external sources such as electromagnetic interference (EMI) or from internal circuit imbalances. As electronic systems demand higher precision and improved power efficiency, the ability to suppress common-mode noise and correct gain mismatches in ADCs has become increasingly important.

Many ADC-based systems rely on differential signal processing to enhance noise immunity and improve the common-mode rejection ratio (CMRR). However, achieving high CMRR and maintaining signal integrity remains challenging due to factors such as component mismatches, parasitic capacitances, and/or environmental noise. This issue is particularly prominent in high-precision applications, such as bio signal monitoring, industrial sensing, and/or wireless communication.

Various approaches for improving CMRR in signal processing systems have been explored, but they have proven to be insufficient. It is important to recognize the need for new and improved systems and methods.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a simplified diagram illustrating an analog-to-digital conversion system according to embodiments of the subject technology.
Figure 2 is a simplified diagram illustrating an analog-to-digital conversion system according to embodiments of the subject technology.
Figure 3 is a simplified diagram illustrating a signal flow within an analog-to-digital conversion system according to embodiments of the subject technology.

### DETAILED DESCRIPTION OF THE INVENTION

The subject technology is directed to signal processing systems and methods. In an embodiment, the subject technology provides an apparatus that includes a first input terminal configured to receive a first input signal and a second input terminal configured to receive a second input signal. The apparatus further includes a first converter coupled to the first input terminal and configured to generate a first signal based at least on the first input signal, and a second converter coupled to the second input terminal and configured to generate a second signal based at least on the second input signal. A first circuit is coupled to the first converter and the second converter and is configured to determine a gain mismatch between the first converter and the second converter based at least on the first signal and the second signal. The first circuit is further configured to adjust the first signal or the second signal based on the gain mismatch to improve common-mode rejection and reduce differential signal distortion. By compensating for gain mismatch in the digital domain, the apparatus improves the common-mode rejection ratio (CMRR) and enhances the accuracy and reliability of analog-to-digital conversion. There are other embodiments as well.

As previously noted, analog-to-digital converters (ADCs) play an important role in converting analog signals into digital data for processing in a wide range of applications, such as health sensing devices, industrial automation, and communication systems. For example, the term "analog-to-digital converter" may refer to a device or circuit that converts a continuous analog signal into a discrete digital representation. Examples of ADCs may include, without limitation, successive approximation register (SAR) ADCs, discrete-time ADCs, noise-shaped SAR (NS-SAR) ADCs, delta-sigma ADCs, pipelined ADCs, flash ADCs, hybrid ADCs, dual-slope ADCs, single-slope ADCs, and/or the like.

Many ADC-based applications require a high CMRR to ensure that differential signals are accurately processed while minimizing interference from environmental noise and system variations. For example, the term "common-mode rejection ratio" may refer to the ability of a differential circuit to reject common-mode interference. It may be expressed in decibels (dB) and calculated as the ratio of the differential gain to the common-mode gain. However, achieving high CMRR in ADCs remains a challenge due to gain mismatches between differential signal paths, which can lead to common-mode-to-differential conversion errors that degrade system performance.

Some approaches for improving CMRR in ADCs rely on fully differential architectures or integrated input common-mode feedback (ICMFB) circuits to suppress common-mode noise before conversion. For example, ICMFB circuits actively sense and cancel common-mode signals using additional analog components, but this approach increases power consumption and silicon area, making it less suitable for power-constrained applications such as wearable devices, battery-operated sensors, and/or mobile communication systems. Additionally, calibration-based analog correction methods may be employed to address gain mismatches, but these methods are sensitive to environmental variations and device aging, limiting their long-term effectiveness.

In various embodiments, the subject technology provides systems and methods for enhancing common-mode rejection using digital gain mismatch correction in signal conversion systems. The system employs a pseudo-differential ADC architecture in which two independent single-ended ADCs digitize the positive and negative input signals separately. By preserving the common-mode signal in the digital domain, this approach enables post-conversion digital correction for gain mismatches, ensuring effective common-mode rejection without relying on power-intensive analog feedback loops. The digital correction logic requires minimal circuit area and power, making it scalable for integration into advanced ADC architectures while maintaining energy efficiency in low-power applications.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus comprising a first input terminal configured to receive a first input signal and a second input terminal configured to receive a second input signal. The apparatus further comprises a first converter coupled to the first input terminal and configured to generate a first signal based on the first input signal. The apparatus further comprises a second converter coupled to the second input terminal and configured to generate a second signal based on the second input signal. The apparatus further comprises a first circuit coupled to the first converter and the second converter, the first circuit being configured to: determine a gain mismatch between the first converter and the second converter based at least on the first signal and the second signal; and adjust the first signal or the second signal based on the gain mismatch.

Implementations may include one or more of the following features. The second input signal and the first input signal comprise a differential component and a common-mode component. The first circuit is configured to: generate a third signal by adjusting the first signal based on the gain mismatch; and generate a fourth signal by adjusting the second signal based on the gain mismatch. The first circuit is configured to generate an output signal based at least on the third signal and the fourth signal. The first circuit is configured to generate the output signal by subtracting the fourth signal from the third signal. The apparatus further comprises a memory configured to store the gain mismatch. The first signal comprises an analog signal. The first converter comprises an analog-to-digital converter (ADC). The first converter is characterized by a first gain factor, the second converter is characterized by a second gain factor, the gain mismatch is associated with the first gain factor and the second gain factor.

According to another embodiment, the subject technology provides an apparatus that comprises a first input terminal configured to receive a first input signal and a second input terminal configured to receive a second input signal. The apparatus further comprises a first converter coupled to the first input terminal and configured to generate a first signal based on the first input signal. The apparatus further comprises a second converter coupled to the second input terminal and configured to generate a second signal based on the second input signal. The apparatus further comprises a first circuit coupled to the first converter and the second converter, the first circuit being configured to: generate a third signal by adjusting the first signal based on a gain mismatch between the first converter and the second converter; generate a fourth signal by adjusting the second signal based on the gain mismatch; and generate an output signal based at least on the third signal and the fourth signal.

Implementations may include one or more of the following features. The second input signal and the first input signal comprise a differential component and a common-mode component. The first circuit is configured to generate the output signal by subtracting the fourth signal from the third signal. The first signal comprises an analog signal. The apparatus further comprises a memory configured to store the gain mismatch. The first converter is characterized by a first gain factor, the second converter is characterized by a second gain factor, the gain mismatch is associated with the first gain factor and the second gain factor.

According to yet another embodiment, the subject technology provides an apparatus that comprises a first input terminal configured to receive a first input signal and a second input terminal configured to receive a second input signal. The apparatus further comprises a first converter coupled to the first input terminal and configured to generate a first signal based on the first input signal. The apparatus further comprises a second converter coupled to the second input terminal and configured to generate a second signal based on the second input signal. The apparatus further comprises a first circuit coupled to the first converter and the second converter, the first circuit being configured to: determine a gain mismatch between the first converter and the second converter based at least on the first signal and the second signal; generate a third signal by adjusting the first signal based on the gain mismatch; generate a fourth signal by adjusting the second signal based on the gain mismatch; and generate an output signal based at least on the third signal and the fourth signal. In various embodiments, the second input signal and the first input signal comprise a differential component and a common-mode component. The first signal comprises an analog signal. The apparatus further comprises a memory configured to store the gain mismatch.

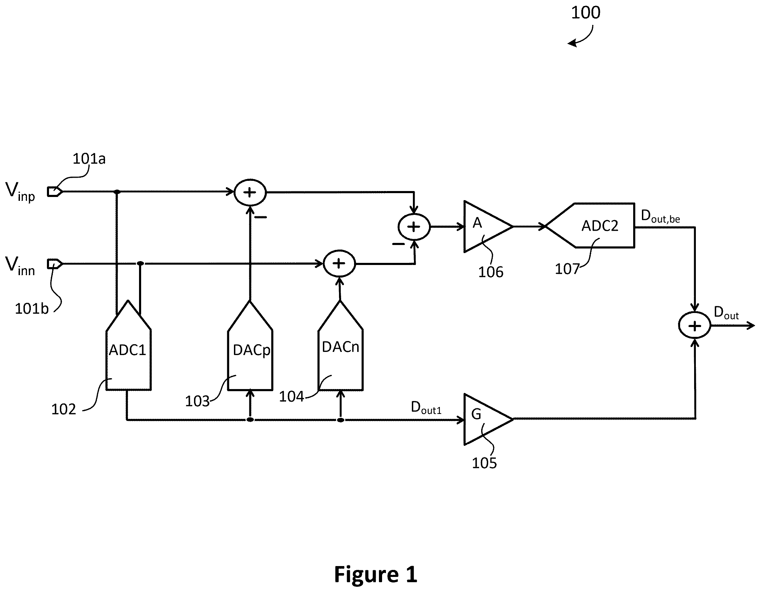

Figure 1 is a simplified diagram illustrating an analog-to-digital conversion system 100 according to embodiments of the subject technology. This diagram merely provides an example, which should not unduly limit the scope of the claims. One of ordinary skill in the art would recognize many variations, alternatives, and modifications. System 100 may be implemented as a SAR ADCs, discrete-time ADCs, NS-SAR ADCs, delta-sigma ADCs, pipelined ADCs, flash ADCs, hybrid ADCs, dual-slope ADCs, single-slope ADCs, and/or the like. Depending on the application, system 100 may incorporate various features such as oversampling, noise shaping, calibration, pseudo-differential processing, digital gain correction, common-mode rejection enhancements, and/or the like.

System 100 may be applied to a wide range of applications, including health monitoring devices, industrial automation, and communication systems. For instance, in health-sensing devices such as wearable electronics, ADCs enable features like electrocardiogram (EKG) measurement, heart rate monitoring, and/or gesture recognition by converting analog signals generated by sensors into digital data for further analysis and processing. These digital outputs are then used to extract physiological parameters, such as heart rhythms or movement patterns, providing real-time feedback for medical or fitness applications.

In various implementations, system 100 employs a pipeline ADC architecture, which processes input signals in multiple stages to achieve high-resolution signal conversion. For instance, the signal conversion process may include a front-end stage and a back-end stage. The front-end stage performs coarse quantization of the input signal, generating an approximate digital representation. The back-end stage then refines this approximation through fine quantization to provide precise digital conversion.

In some embodiments, system 100 includes one or more input terminals, which may be configured to receive input signals. For instance, system 100 includes first input terminal 101a and second input terminal 101b. First input terminal 101a may be configured to receive a first input signal (e.g., Vᵢₙₚ), and second input terminal 101b may be configured to receive a second input signal (e.g., Vᵢₙₙ). For example, the term "input terminal" may refer to a physical or electrical interface configured to accept an external signal for processing within the system. Examples of input terminals may include, without limitation, physical pins, pads, connectors, wireless interfaces, and/or the like.

In some examples, the input signal may include a differential analog signal, which includes two complementary components (e.g., Vᵢₙₚ and Vᵢₙₙ). A differential signal may be characterized by the voltage difference between its two components, which conveys the information to be processed. However, in practical implementations, differential signal paths may be subject to common-mode interference, where identical noise or interference affects both components of the differential signal. In the presence of gain mismatches or other imperfections in the circuit components, a portion of the common-mode signal may be converted into a differential-mode signal, leading to reduced accuracy and increased noise in the digitized output. Therefore, it is desirable to suppress common-mode interference effectively to preserve the integrity of the differential signal and ensure precise analog-to-digital conversion.

According to some examples, The input signals (e.g., Vᵢₙₚ and Vᵢₙₙ) may be processed by the front-end stage, which includes front-end ADC (FE-ADC) 102 and one or more front-end digital-to-analog converters (FE-DAC) (e.g., first DAC 103 and/or second DAC 104). For example, the term "digital-to-analog converter" may refer to a device or circuit that converts a discrete digital signal into a continuous analog signal. Examples of DACs may include, without limitation, binary weighted DACs, resistor-string DACs, R-2R ladder DACs, segmented DACs, delta-sigma DACs, pulse-width modulation (PWM) DACs, and/or the like.

In some implementations, FE-ADC 102 is configured to perform an initial quantization of the input signals (e.g., Vᵢₙₚ and Vᵢₙₙ) and generate a digital output signal (e.g., Dₒᵤₜ₁), which may represent a coarse approximation of the input signal. To refine this approximation, Dₒᵤₜ₁ may be converted back to an analog signal by FE-DACs 103 and/or 104. In some cases, the output of FE-DACs may be subtracted from the original input signals (e.g., Vᵢₙₚ and Vᵢₙₙ) to generate a residue voltage. The residue voltage represents the difference between the original input signal and the coarse approximation provided by Dₒᵤₜ₁ and may be significantly smaller in magnitude than the original input signal.

In various embodiments, the residue voltage may be amplified by amplifier 106 before it is fed to back-end ADC (BE-ADC) 107 for subsequent processing. For example, the term "amplifier" may refer to may refer to a device or circuit that increases the amplitude of a signal. Examples of amplifiers may include, without limitation, operational amplifiers (op-amps), instrumentation amplifiers, differential amplifiers, programmable gain amplifiers, and/or the like. In some examples, amplifier 106 scales the residue voltage to a level suitable for fine quantization, relaxing the noise and linearity requirements for BE-ADC 107. BE-ADC 107 then processes the amplified residue voltage to generate a high-resolution digital output (e.g., D_{out, be}), which provides precise quantization of the finer details of the input signal.

In some implementations, the final digital output (e.g., Dₒᵤₜ) may be constructed by combining Dₒᵤₜ₁ and D_{out, be}. To align the coarse and fine quantization, digital gain block 105 may be configured to scale Dₒᵤₜ₁ by a gain factor G at digital gain block 105, which may be nominally equal to the gain of amplifier 106. This scaling ensures that the contribution from the coarse quantization matches the magnitude of the fine quantization for proper summation. The scaled coarse output and the fine output are then combined to generate the final digital output (e.g., Dₒᵤₜ), which represents the high-resolution digital approximation of the original input signals.

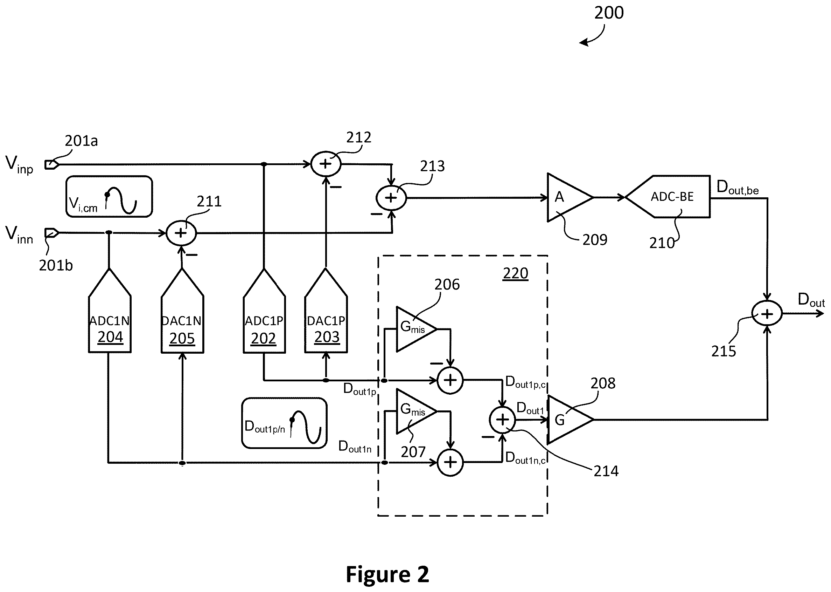

Figure 2 is a simplified diagram illustrating an analog-to-digital conversion system 200 according to embodiments of the subject technology. This diagram merely provides an example, which should not unduly limit the scope of the claims. One of ordinary skill in the art would recognize many variations, alternatives, and modifications.

In some embodiments, system 200 includes one or more input terminals, which may be configured to receive input signals. For instance, system 200 includes first input terminal 201a and second input terminal 201b. First input terminal 201a may be configured to receive a first input signal (e.g., Vᵢₙₚ), and second input terminal 201b may be configured to receive a second input signal (e.g., Vᵢₙₙ). In some cases, the input terminals may also include signal conditioning circuitry to prepare the signal for further processing.

In some implementations, the input signal includes a common-mode component (e.g.,V_{i,cm}) and a differential-mode component (e.g.,Vᵢₙₚ-Vᵢₙₙ). For example, the term "differential-mode component" or "differential component" may refer to a portion of a signal that conveys the information of interest and is represented by the voltage difference between two complementary signal components. The term "common-mode component" may refer to a portion of a signal that is common to both input terminals, representing the average voltage level of the two signals. In order to ensure precise analog-to-digital conversion, it is desired to reject or suppress common-mode components while preserving the integrity of the differential-mode component.

In some examples, system 200 may be implemented as a pipeline ADC architecture, which includes a front-end stage and a back-end stage. For instance, the front-end stage is configured to perform coarse quantization and generate a digital approximation of the input signals, which is further refined in the back-end stage to achieve high-resolution digital conversion. The input signals may originate from a variety of sources, such as biomedical sensors capturing physiological data (e.g., electrocardiogram or blood pressure signals), industrial sensors monitoring environmental conditions (e.g., temperature, pressure, or vibration), and/or communication systems processing radio-frequency or baseband signals.

In various implementations, system 200 further includes one or more converters coupled to the input terminal. For example, the term "converter" may refer to a circuit or system that transforms a signal from one form to another, such as from analog to digital or vice versa. Examples of converters may include, without limitation, ADCs, DACs, frequency-to-voltage converters, voltage-to-frequency converters, and/or the like. For instance, system 200 may include at least one of first ADC 202, first DAC 203, second ADC 204, second DAC 205, and/or the like.

In some examples, first ADC 202 may be coupled to first input terminal 201a and configured to generate a first signal (e.g., Dₒᵤₜ₁ₚ) based on the first input signal (e.g., V_{ing}). Second ADC 204 may be coupled to second input terminal 201b and configured to generate a second signal (e.g., Dₒᵤₜ₁ₙ) based on the second input signal (e.g., Vᵢₙₙ). In some cases, first ADC 202 and second ADC 204 may include single-ended ADCs and are responsible for converting the respective analog input signals into digital representations, allowing for further processing in the digital domain. These digitized outputs (e.g., the first signal and the second signal) provide coarse approximations of the input signals, which may be used to compute residue signals for subsequent stages. By processing the positive (e.g., Vᵢₙₚ) and negative (e.g., Vᵢₙₙ) components separately, system 200 retains both common-mode and differential-mode components in the digital domain, allowing for post-conversion digital correction of gain mismatches and effective suppression of common-mode interference in subsequent stages.

According to some embodiments, first DAC 203 may be coupled to first ADC 202, and second DAC 205 may be coupled to second ADC 204. For instance, first DAC 203 and second DAC 205 may be configured to convert the first signal and the second signal into corresponding analog signals (e.g., a first analog signal and a second analog signal), which may be used to generate a residue voltage representing the difference between the input signal and its coarse quantization. For instance, the first analog signal may be subtracted from the first input signal (e.g., Vᵢₙₚ) at node 212. The second analog signal may be subtracted from the second input signal (e.g., Vᵢₙₙ) at node 211. By subtracting these analog signals from the original input signals, nodes 211 and 212 generate residue signals by isolating the unquantized portions of the input signals. In some examples, node 213 receives the outputs from nodes 211 and 212 and combines them to generate a differential residue signal. The residue signal represents the "remaining" portion of the input signal that has not yet been quantized at the front-end stage, and it may be passed to subsequent stages (e.g., back-end stage) for fine quantization to achieve higher resolution.

As previously explained, analog-to-digital conversion systems often face challenges with common-mode rejection and gain mismatches, which can significantly degrade the performance of the system. To address these issues, system 200 may include first circuit 220, which may be used to perform digital correction to enhance common-mode rejection and compensate for gain mismatches in the digital domain. For instance, first circuit 220 may be coupled to one or more converters (e.g., first ADC 202 and/or second ADC 204) and configured to receive the first signal (e.g., Dₒᵤₜ₁ₚ) and the second signal (e.g., Dₒᵤₜ₁ₙ) from the respective ADCs.

In some embodiments, first circuit 220 is configured to determine a gain mismatch (e.g., Gₘᵢₛ) between first ADC 202 and second ADC 204 by analyzing the amplitude differences between the first signal and the second signal and computing a correction factor based on predefined calibration values or runtime signal measurements. For example, the term "gain mismatch" may refer to a discrepancy between the gain factors of two signal paths that are intended to process complementary components of a differential signal.

As an example, the gain mismatch may be associated with the gain factors of one or more converters. For instance, the first ADC 202 may be characterized by a first gain factor (e.g., G_{adc1p}), and the second ADC 204 may be characterized by a second gain factor (e.g., G_{adc1n}). For example, the term "gain factor" may refer to a multiplicative parameter that quantifies the amplification or attenuation applied to an input signal by a circuit component. The gain factor may reflect how an input voltage or current is scaled in the conversion process. The gain mismatch may be associated with the first gain factor and the second gain factor. In ideal conditions, the gain of the positive signal path (e.g., associated with Dₒᵤₜ₁ₚ) and the gain of the negative signal path (e.g., associated with Dₒᵤₜ₁ₙ) should be equal. However, due to variations in circuit components, fabrication processes, or environmental conditions (e.g., temperature fluctuations, power supply variations, and/or the like), the gains of these signal paths may differ. The gain mismatch may lead to partial conversion of common-mode signals into differential-mode signals, resulting in degraded CMRR and potential errors in downstream signal processing. In some implementations, the gain mismatch may be calculated as follows: ${G}_{mis} = \frac{{G}_{adc 1 p} - {G}_{adc 1 n}}{{G}_{adc 1 p} + {G}_{adc 1 n}}$ where *G*_{*adc*1*p*} represents the gain factor of first ADC 202 (e.g., positive signal path) and *G*_{*adc*1*n*} represents the gain factor of second ADC 204 (e.g., negative signal path). The gain mismatch factor quantifies the relative difference between the two ADC gain factors and serves as the basis for digital correction applied in first circuit 220.

In some examples, first circuit 220 includes first gain correction block 206, which may be coupled to first ADC 202. First gain correction block 206 may be configured to adjust the first signal (e.g., Dₒᵤₜ₁ₚ) based on the gain mismatch. For instance, first gain correction block 206 is configured to generate a third signal (e.g., D_{out1p,c}) by applying a first scaling factor to the first signal (e.g., Dₒᵤₜ₁ₚ). The first scaling factor may be determined based on the gain mismatch. In other aspects, first circuit 220 may include second gain correction block 207, which may be coupled to second ADC 204. Second gain correction block 207 may be configured to adjust the second signal (e.g., Dₒᵤₜ₁ₙ) based on the gain mismatch. For instance, second gain correction block 207 may be configured to generate a fourth signal (e.g., D_{out1n,c}) by applying a second scaling factor to the second signal (e.g., Dₒᵤₜ₁ₙ). The second scaling factor may be determined based on the gain mismatch.

For example, the term "scaling factor" may refer to a numerical value or coefficient that is applied to a signal to modify its amplitude. Depending on the implementation, the first and second scaling factors may be predetermined using factory-calibrated values stored in memory, adaptive correction based on real-time monitoring of signal imbalances, or a look-up table (LUT) containing precomputed correction factors for different operating conditions. As an example, the first scaling factor may be calculated as 1 - *Gₘᵢₛ,* and the second scaling factor may be calculated as 1 + *Gₘᵢₛ.* In some embodiments, first circuit 220 may be configured to generate an output signal (e.g., Dₒᵤₜ₁) based at least on the third signal (e.g., D_{out1p,c}) and the fourth signal (e.g., D_{out1n,c}). For instance, the output signal may be generated by combining the third signal and the fourth signal at node 214. As an example, the output signal (e.g., Dₒᵤₜ₁) may be calculated as follows: ${D}_{out 1} = {D}_{out 1 p , c} - {D}_{out 1 n , c}$ By performing this subtraction, any remaining common-mode component-which is equally present in both *D*_{*ouc*1*p,c*} and *D*_{*out*1*n,c*}-is removed, ensuring that the resulting signal is free from common-mode interference.

By performing gain correction and common-mode noise cancellation in the digital domain, this approach eliminates the need for complex analog-domain correction circuits, reducing power consumption and silicon area. Additionally, digital correction techniques are scalable and can be adapted for different operating conditions without requiring modifications to the physical circuit design, ensuring long-term stability and reliability across process, voltage, and temperature (PVT) variations.

In some examples, the output signal (e.g., Dₒᵤₜ₁) may be further processed by digital gain block 208, which is configured to scale the output signal from the front-end stage to match the magnitude of the back-end stage output. Digital gain block 208 ensures that the digitized coarse and fine quantization results are properly aligned, allowing for accurate reconstruction of the original input signal.

In various implementations, system 200 further includes second amplifier 209, which may be coupled to the front-end stage (e.g., node 213). Amplifier 209 may be configured to process the residue signal generated by the front-end stage. For instance, amplifier 209 is configured to scale the residue voltage to a level suitable for fine quantization in the subsequent stages, relaxing the noise and linearity requirements for BE-ADC 210. BE-ADC 210 then processes the amplified residue voltage to generate a high-resolution digital output (e.g., D_{out, be}), which provides precise quantization of the finer details of the input signal. In some cases, the output of digital gain block 208 is then combined with the output of second amplifier 209 (e.g., D_{out, be}) at node 215 to generate the final corrected digital output (e.g., Dₒᵤₜ).

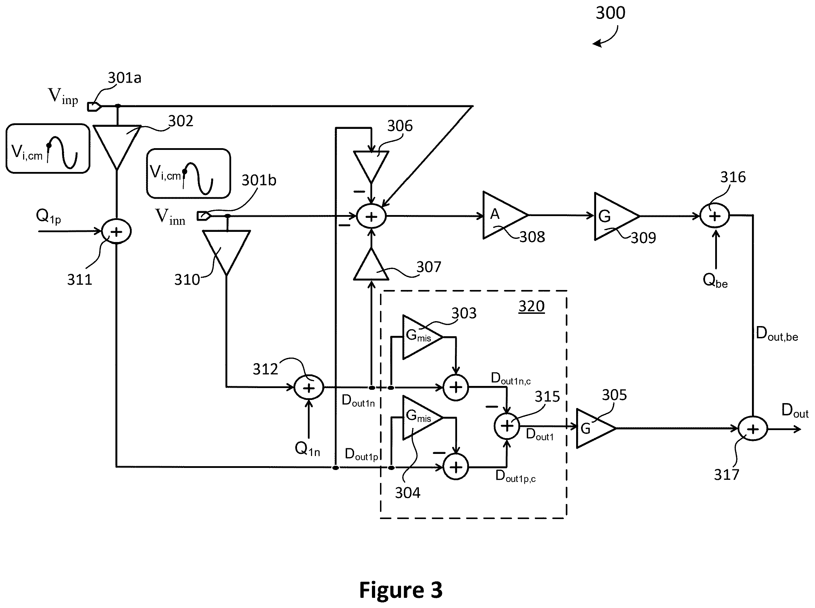

Figure 3 is a simplified diagram illustrating a signal flow within an analog-to-digital conversion system 300 according to embodiments of the subject technology. This diagram merely provides an example, which should not unduly limit the scope of the claims. One of ordinary skill in the art would recognize many variations, alternatives, and modifications.

In some embodiments, system 300 includes first input terminal 301a and second input terminal 301b, which may be configured to receive input signals Vᵢₙₚ and Vᵢₙₙ, respectively. The input signals may contain both a differential-mode component and a common-mode component (e.g., V_{i,cm}). The differential component represents the primary information content of the signal, and the common-mode component is an unwanted noise element that needs to be suppressed. In some examples, first input terminal 301a may be coupled to first ADC 302. Second input terminal 301b may be coupled to second ADC 310. First ADC 302 and second ADC 310 may be configured to perform an initial digitization of the input signals, generating a first signal (e.g., Dₒᵤₜ₁ₚ) and a second input signal (e.g., Dₒᵤₜ₁ₙ), respectively.

According to some embodiments, first DAC 306 may be coupled to first ADC 302, and second DAC 307 may be coupled to second ADC 310. For instance, first DAC 306 and second DAC 307 may be configured to convert digital signals Dₒᵤₜ₁ₚ and Dₒᵤₜ₁ₙ into corresponding analog signals, which may be used to generate a residue voltage representing the difference between the input signal and its coarse quantization.

In system 300, ADCs and DACs are modeled using their gain characteristics and associated quantization noise. For instance, first ADC 302 and second ADC 310 are represented by their respective gain factors and additive quantization noise components 311 and 312, respectively. Similarly, the back-end ADC is modeled by its equivalent gain block 309 and additive quantization noise at node 316. These models capture the impact of gain variations and quantization noise on the signal transformation process, allowing for analytical representation of the conversion stages.

To address common-mode rejection issues and gain mismatches, first circuit 320 may be configured to determine a gain mismatch (e.g., Gₘᵢₛ) between first ADC 302 and second ADC 310 and compute a correction factor based on predefined calibration values or runtime signal measurements. For example, first circuit 320 is configured to determine the gain mismatch by analyzing the amplitude differences between the signals from first ADC 302 and second ADC 310 (e.g., Dₒᵤₜ₁ₚ and Dₒᵤₜ₁ₙ). This analysis may be based on real-time signal monitoring, pre-calibrated values stored in memory, LUTs containing precomputed correction factors for different operating conditions, and/or the like.

In some examples, the gain mismatch may be associated with the gain factors of one or more converters. For instance, the first ADC 302 may be characterized by a first gain factor (e.g., G_{adc1p}), and the second ADC 310 may be characterized by a second gain factor (e.g., G_{adc1n}). The gain mismatch may be associated with the first gain factor and the second gain factor. In some cases, the gain mismatch (e.g., Gₘᵢₛ) may be determined through a calibration procedure by measuring the relative gain factors of the positive and negative signal paths (e.g., the first and second gain factors). For example, the gain factors of the P-channel (e.g., G_{adc1p}) and N-channel (e.g., G_{adc1n}) ADCs may be measured by injecting a known common-mode signal (e.g., V_{i,cm}) into both the P and N inputs, respectively. Because a common-mode signal ideally produces identical outputs in both channels, any observed difference in the first-stage digital outputs (e.g., D_{out1p,c} and D_{out1n,c}) directly reflects the gain mismatch between the channels. For instance, the gain mismatch may be calculated as follows: ${G}_{mis} = \frac{{G}_{adc 1 p} - {G}_{adc 1 n}}{{G}_{adc 1 p} + {G}_{adc 1 n}}$

It is to be appreciated that the gain mismatch factor quantifies the relative difference between the two ADC gain factors and serves as the correction factor for subsequent digital compensation. Depending on the implementation, the calibration procedure may be performed once during automated test equipment (ATE) testing, at power-on, or continuously in the background during normal operation. In some implementations, the optimal gain mismatch correction factor may be stored in memory for later retrieval and reuse. For example, the term "memory" may refer to a storage medium or circuit capable of retaining data. Examples of memory may include, without limitation, non-volatile memory (NVM), volatile memory, register-based memory, look-up tables, and/or the like.

In some examples, first circuit 320 includes first gain correction block 304, which may be coupled to first ADC 302. For instance, first gain correction block 304 is configured to generate a third signal (e.g., D_{out1p,c}) by applying a first scaling factor to the first signal (e.g., Dₒᵤₜ₁ₚ). The first scaling factor may be determined based on the gain mismatch. In other aspects, first circuit 220 may include second gain correction block 303, which may be coupled to second ADC 310. For instance, second gain correction block 303 may be configured to generate a fourth signal (e.g., D_{out1n,c}) by applying a second scaling factor to the second signal (e.g., Dₒᵤₜ₁ₙ). The second scaling factor may be determined based on the gain mismatch. The scaling factors ensure that the gain factor of the P-channel matches the gain factor of the N-channel, thereby preventing any unintended conversion of common-mode signals into differential signals.

As an example, the first scaling factor may be calculated as 1 - *Gₘᵢₛ,* and the second scaling factor may be calculated as 1 + *Gₘᵢₛ*. In some examples, first circuit 320 may be configured to generate an output signal (e.g., Dₒᵤₜ₁) based at least on the third signal (e.g., D_{out1p,c}) and the fourth signal(e.g., D_{out1n,c}). For instance, the output signal may be generated by combining the third signal and the fourth signal at node 315. As an example, the output signal (e.g., Dₒᵤₜ₁) may be calculated as follows: ${D}_{out 1} = {D}_{out 1 p , c} - {D}_{out 1 n , c}$

In some examples, the correction applied by first circuit 320 ensures that the common-mode to differential-mode (CM-DM) gain is effectively canceled, preventing unwanted conversion of common-mode noise into differential signals. For instance, the CM-DM gain may be expressed as: $CM - DM Gain = {G}_{adc 1 p} \left(1-{G}_{mis}\right) - {G}_{adc 1 n} \left(1+{G}_{mis}\right)$ By applying the correction factor, the CM-DM gain is forced to zero, ensuring that common-mode interference does not propagate into the differential output.

In various implementations, first circuit 320 ensures that the corrected signals (e.g., D_{out1p,c} and D_{out1n,c}) maintain the desired signal integrity by continuously monitoring and adjusting the correction factors in response to environmental variations such as temperature drift, voltage fluctuations, or process-induced mismatches. This digital correction approach improves the CMRR and enhances overall conversion accuracy without requiring power-hungry analog-domain compensation circuits.

In some examples, the output signal (e.g., Dₒᵤₜ₁) may be further processed by digital gain block 305, which is configured to scale the output signal from the front-end stage to match the magnitude of the back-end stage output. In various implementations, system 300 further includes second amplifier 308, which may be coupled to the front-end stage. Second amplifier 308 may be configured to process the residue signal generated by the front-end stage. For instance, amplifier 308 is configured to scale the residue voltage to a level suitable for fine quantization in the subsequent stages. In some aspects, system 300 further includes back-end ADC 309 (e.g., modeled by its equivalent gain block), which may be coupled to the front-end stage. Back-end ADC 309 may be configured to process the residue signal generated by the front-end stage. For instance, back-end ADC 309 is configured to scale the residue voltage to a level suitable for fine quantization in the back-end stage. In some embodiments, the corrected back-end output signal (e.g., D_{out, be}) is then combined with the front-end corrected output signal at node 317 to generate the final corrected digital output (e.g., Dₒᵤₜ).

While the above is a full description of the specific embodiments, various modifications, alternative constructions and equivalents may be used. Therefore, the above description and illustrations should not be taken as limiting the scope of the subject technology which is defined by the appended claims.

The invention further comprises the following embodiments forming part of the description:
1. An apparatus comprising:
   a first input terminal configured to receive a first input signal;
   a second input terminal configured to receive a second input signal;
   a first converter coupled to the first input terminal and configured to generate a first signal based on the first input signal;
   a second converter coupled to the second input terminal and configured to generate a second signal based on the second input signal; and
   a first circuit coupled to the first converter and the second converter, the first circuit being configured to:
      determine a gain mismatch between the first converter and the second converter based at least on the first signal and the second signal; and
      adjust the first signal or the second signal based on the gain mismatch.
2. The apparatus of embodiment 1, wherein the second input signal and the first input signal comprise a differential component and a common-mode component.
3. The apparatus of embodiment 1, wherein the first circuit is configured to:
   generate a third signal by adjusting the first signal based on the gain mismatch; and
   generate a fourth signal by adjusting the second signal based on the gain mismatch.
4. The apparatus of embodiment 3, wherein the first circuit is configured to generate an output signal based at least on the third signal and the fourth signal.
5. The apparatus of embodiment 4, wherein the first circuit is configured to generate the output signal by subtracting the fourth signal from the third signal.
6. The apparatus of embodiment 1, further comprising a memory configured to store the gain mismatch.
7. The apparatus of embodiment 1, wherein the first signal comprises an analog signal.
8. The apparatus of embodiment 1, wherein the first converter comprises an analog-to-digital converter (ADC).
9. The apparatus of embodiment 1, wherein the first converter is characterized by a first gain factor, the second converter is characterized by a second gain factor, the gain mismatch is associated with the first gain factor and the second gain factor.
10. An apparatus comprising:
   a first input terminal configured to receive a first input signal;
   a second input terminal configured to receive a second input signal;
   a first converter coupled to the first input terminal and configured to generate a first signal based on the first input signal;
   a second converter coupled to the second input terminal and configured to generate a second signal based on the second input signal; and
   a first circuit coupled to the first converter and the second converter, the first circuit being configured to:
      generate a third signal by adjusting the first signal based on a gain mismatch between the first converter and the second converter;
      generate a fourth signal by adjusting the second signal based on the gain mismatch; and
      generate an output signal based at least on the third signal and the fourth signal.
11. The apparatus of embodiment 10, wherein the second input signal and the first input signal comprise a differential component and a common-mode component.
12. The apparatus of embodiment 10, wherein the first circuit is configured to generate the output signal by subtracting the fourth signal from the third signal.
13. The apparatus of embodiment 10, wherein the first signal comprises an analog signal.
14. The apparatus of embodiment 10, further comprising a memory configured to store the gain mismatch.
15. The apparatus of embodiment 10, wherein the first converter is characterized by a first gain factor, the second converter is characterized by a second gain factor, the gain mismatch is associated with the first gain factor and the second gain factor.
16. An apparatus comprising:
   a first input terminal configured to receive a first input signal;
   a second input terminal configured to receive a second input signal;
   a first converter coupled to the first input terminal and configured to generate a first signal based on the first input signal;
   a second converter coupled to the second input terminal and configured to generate a second signal based on the second input signal; and
   a first circuit coupled to the first converter and the second converter, the first circuit being configured to:
      determine a gain mismatch between the first converter and the second converter based at least on the first signal and the second signal;
      generate a third signal by adjusting the first signal based on the gain mismatch;
      generate a fourth signal by adjusting the second signal based on the gain mismatch; and
      generate an output signal based at least on the third signal and the fourth signal.
17. The apparatus of embodiment 16, wherein the second input signal and the first input signal comprise a differential component and a common-mode component.
18. The apparatus of embodiment 16, wherein the first signal comprises an analog signal.
19. The apparatus of embodiment 16, further comprising a memory configured to store the gain mismatch.
20. The apparatus of embodiment 16, wherein the first converter is characterized by a first gain factor, the second converter is characterized by a second gain factor, the gain mismatch is associated with the first gain factor and the second gain factor.

## Claims

1. An apparatus comprising:
a first input terminal configured to receive a first input signal;
a second input terminal configured to receive a second input signal;
a first converter coupled to the first input terminal and configured to generate a first signal based on the first input signal;
a second converter coupled to the second input terminal and configured to generate a second signal based on the second input signal; and
a first circuit coupled to the first converter and the second converter, the first circuit being configured to:
determine a gain mismatch between the first converter and the second converter based at least on the first signal and the second signal; and
adjust the first signal or the second signal based on the gain mismatch.

2. The apparatus according to claim 1, wherein the second input signal and the first input signal comprise a differential component and a common-mode component.

3. The apparatus according to at least one of claims 1 or 2, wherein the first circuit is configured to:
generate a third signal by adjusting the first signal based on the gain mismatch; and
generate a fourth signal by adjusting the second signal based on the gain mismatch.

4. The apparatus according to claim 3, wherein the first circuit is configured to generate an output signal based at least on the third signal and the fourth signal, and wherein the first circuit is configured to generate the output signal in particular by subtracting the fourth signal from the third signal.

5. The apparatus according to at least one of the preceding claims, further comprising a memory configured to store the gain mismatch.

6. The apparatus according to at least one of the preceding claims, wherein the first signal comprises an analog signal.

7. The apparatus according to at least one of the preceding claims, wherein the first converter comprises an analog-to-digital converter (ADC).

8. The apparatus according to at least one of the preceding claims, wherein the first converter is **characterized by** a first gain factor, the second converter is **characterized by** a second gain factor, the gain mismatch is associated with the first gain factor and the second gain factor.

9. An apparatus comprising:
a first input terminal configured to receive a first input signal;
a second input terminal configured to receive a second input signal;
a first converter coupled to the first input terminal and configured to generate a first signal based on the first input signal;
a second converter coupled to the second input terminal and configured to generate a second signal based on the second input signal; and
a first circuit coupled to the first converter and the second converter, the first circuit being configured to:
generate a third signal by adjusting the first signal based on a gain mismatch between the first converter and the second converter;
generate a fourth signal by adjusting the second signal based on the gain mismatch; and
generate an output signal based at least on the third signal and the fourth signal.

10. The apparatus according to claim 9, wherein the second input signal and the first input signal comprise a differential component and a common-mode component, and/or
wherein the first circuit is configured to generate the output signal by subtracting the fourth signal from the third signal.

11. The apparatus according to at least one of claims 9 or 10, wherein the first signal comprises an analog signal, and/or
wherein the apparatus further comprises a memory configured to store the gain mismatch.

12. The apparatus according to at least one of claims 9 to 11, wherein the first converter is **characterized by** a first gain factor, the second converter is **characterized by** a second gain factor, the gain mismatch is associated with the first gain factor and the second gain factor.

13. An apparatus comprising:
a first input terminal configured to receive a first input signal;
a second input terminal configured to receive a second input signal;
a first converter coupled to the first input terminal and configured to generate a first signal based on the first input signal;
a second converter coupled to the second input terminal and configured to generate a second signal based on the second input signal; and
a first circuit coupled to the first converter and the second converter, the first circuit being configured to:
determine a gain mismatch between the first converter and the second converter based at least on the first signal and the second signal;
generate a third signal by adjusting the first signal based on the gain mismatch;
generate a fourth signal by adjusting the second signal based on the gain mismatch; and
generate an output signal based at least on the third signal and the fourth signal.

14. The apparatus according to claim 13, wherein the second input signal and the first input signal comprise a differential component and a common-mode component, and/or
wherein the first signal comprises an analog signal, and/or
wherein the apparatus further comprises a memory configured to store the gain mismatch.

15. The apparatus according to at least one of claims 13 or 14, wherein the first converter is **characterized by** a first gain factor, the second converter is **characterized by** a second gain factor, the gain mismatch is associated with the first gain factor and the second gain factor.
